# EUROPÄISCHE PATENTSCHRIFT

(11) **EP 1 546 431 B1**
(45) Veröffentlichungstag und Bekanntmachung des Hinweises auf die Patenterteilung: **10.02.2010**
(21) Anmeldenummer: 03798033.1
(22) Anmeldetag: 30.09.2003
(51) Int. Cl.: C23C 14/08, C23C 30/00

(54) **VERBUNDWERKSTOFF**
COMPOSITE MATERIAL
MATERIAU COMPOSITE

(30) Priorität: 30.09.2002 CH 163002
(43) Veröffentlichungstag der Anmeldung: 29.06.2005
(73) Patentinhaber: Incoat GmbH, 8212 Neuhausen am Rheinfall (CH)
(72) Erfinder: MOSER, Eva, Maria, CH-8224 Löhningen (CH)
(74) Vertreter: Wegmann, Urs
(86) Internationale Anmeldenummer: PCT/CH2003/000653
(87) Internationale Veröffentlichungsnummer: WO 2004/029323

(56) Entgegenhaltungen:
- WO-A-01/71055
- DE-A- 2 519 403
- BEN AMOR S ET AL: "Photoprotective titania coatings on PET substrates" SURFACE AND COATINGS TECHNOLOGY, 1 APRIL 1998, ELSEVIER, SWITZERLAND, Bd. 102, Nr. 1-2, Seiten 63-72, XP002240840 ISSN: 0257-8972 in der Anmeldung erwähnt
- RAO K N: "Influence of deposition parameters on optical properties of TiO/sub 2/ films" OPTICAL ENGINEERING, SEPT. 2002, SPIE, USA, Bd. 41, Nr. 9, Seiten 2357-2364, XP001149929 ISSN: 0091-3286

## Beschreibung

Die Erfindung bezieht sich auf einen Verbundwerkstoff aus einem Substrat mit einer wenigstens einseitig aufgebrachten chemisch, physikalisch, mechanisch, katalytisch und/oder optisch funktionalen Titanoxidschicht. Weiter betrifft die Erfindung ein Verfahren zur Herstellung und Verwendungen des Verbundwerkstoffs.

Der weite Begriff Substrat umfasst einerseits leicht entflammbare und/oder wärmeempfindliche Werkstoffe aus Polymeren, polymerartigen oder natürlichen Materialien, aber andererseits auch Werkstoffe aus Metallen, Glas, Keramik und Kombinationen daraus (Komposit-Werkstoffe), bei welchen aus verfahrenstechnischen Gründen ein Beschichtungsprozess bei niedrigen Temperaturen vorgezogen wird. Die Substrate werden mit keramischen Titanoxidschichten, welche eine oder mehrere Schutzwirkung erfüllen und damit beispielsweise die Sicherheit im täglichen Umgang mit leicht entflammbaren und/oder leicht zu verunreinigenden Werkstoffen erhöhen.

Das Brennverhalten von Werkstoffen (insbesondere Textilien, Folien und Behälter aus Kunststoffen) und deren Einschätzung des Brandrisikos ist von großer Bedeutung, weil sie stets den Menschen umgeben. Textilien werden beispielsweise in einer Vielzahl von Anwendungen, hauptsächlich als Kleidung, Heimtextilien und technischen Textilien, eingesetzt. Der Verbrennungsprozess wird durch Erwärmung, Zersetzung und Zündung des brennbaren Werkstoffes eingeleitet. Je nach seiner Beschaffenheit wird der Werkstoff unter Wärmeeinwirkung zunächst schmelzen, fließen oder unverändert bleiben und sich bei weiterer Energiezufuhr schließlich zersetzen und dabei Wärme entwickeln. Nach Zündung des brennbaren Werkstoffs findet die Flammausbreitung über seine zersetzte Oberfläche statt, wobei die Geschwindigkeit der Flammausbreitung mit der Wärmeabgabe des Materials einhergeht. Neben der Entzündbarkeit sind deshalb Flammausbreitung und der Grad der Wärmeabgabe brandbestimmende Parameter.

Der geforderte Flammschutz kann traditionell auf verschiedene Arten erreicht werden. Einerseits können intrinsisch flammgeschützte Polymere wie Polyvinylchlorid (PVC) oder Fluorpolymere verwendet werden. Brennbare Polymere wie Polyethylen (PE), Polypropylen (PP) oder Polyamid (PA) können mit diversen flammhemmenden Füllstoffen (z.B. Aluminiumhydroxid, Magnesiumhydroxid, organische Bromverbindungen) ausgerüstet werden. Meistens ist jedoch ein hoher Anteil dieser Füllstoffe in der Polymermatrix erforderlich, um einen ausreichenden. Flammschutz zu erzielen. Dies äussert sich in einer hohen Dichte, mangelnden Flexibilität und niedrigen mechanischen Eigenschaften des Werkstoffes.

Titandioxid (TiO₂) hat bekannte Eigenschaften als Photohalbleiter, einen hohen Brechungsindex, eine hohe Transparenz im sichtbaren und im Infrarot-nahen Wellenlängenbereich, eine hohe dielektrische Konstante, weist einen sehr guten Verschleissschutz auf, ist chemisch inert und hat schliesslich hervorragende thermische Eigenschaften. TiO₂ kristallisiert in drei Modifikationen: tetragonales Rutil, Anatase und orthorombisches Brookit. Es sind spezielle experimentelle Bedingungen erforderlich, um Brookit herstellen zu können. Rutil ist für optische Anwendungen interessant, währenddem bei Anatase die photokatalytischen Eigenschaften infolge der optischen Bandlücke von 3.2 eV ausgeprägter sind.

Es sind zahlreiche Suboxide von Titan (TiOₓ) mit einem Sauerstoffgehalt von 0.7 ≤ x < 2 bekannt, TiOₓ mit einem Sauerstoffgehalt von 0.7 < x < 1.5 hat bei Raumtemperatur einen elektrischen Widerstand von etwa 400 µΩ cm, bei einem höheren Sauerstoffgehalt nimmt dieser rasch zu, TiO₂ ist ein Isolator.

Es ist bekannt, dass bei TiO₂-Schichten die Kristallinität und deren Modifikationen von der Herstellungsmethode, den Prozessparametern und der Beschichtungskonfiguration abhängen. Meistens werden kristalline TiO₂-Schichten mit Sol-Gel Prozessen, Spray-Pyrolyse, Lackierung, Elektronenstrahlverdampfung oder metall-organisch chemischer Verdampfung (MOCVD) oberhalb 300 °C hergestellt. TiO₂-Schichten, welche mit reaktiver Verdampfung oder Plasma aktivierter chemischer Verdampfungsmethoden (PACVD) unterhalb 300 °C hergestellt werden, sind üblicherweise amorph und weniger dicht. Werden diese amorphen Schichten zwischen 300-500 °C getempert, ist die Struktur Anatase der TiO₂ dominant, bei einer Wärmebehandlung oberhalb 600 °C bildet sich die TiO₂- Modifikation Rutil.

Andererseits können amorphe oder kristalline TiOₓ- bzw. TiO₂₋Schichten unterhalb 300 °C mit Methoden, welche durch eine höhere Teilchenenergie charakterisiert sind - wie z.B. reaktives oder nicht-reaktives Magnetron Sputtern (Kathodenzerstäubung), nicht gefilterte oder gefilterte Funken-Entladung, Ionenstrahlassistierte Abscheidungen (IAD) und gepulste Laserabscheidungen - erzeugt werden. Mit RF-Sputtern kann entsprechend der Wahl der Beschichtungsparameter TiO₂ amorph oder kristallin auf ein ungeheiztes Material abgeschieden werden.

In der SURFACE AND COATINGS TECHNOLOGY 102 (1998), 67 - 72 werden dünne Titandioxidschichten beschrieben, welche durch RF-Sputtern in einer Argon-Sauerstoff-Atmosphäre abgeschieden worden sind. Die Mikrostrukturen der TiO₂-Abscheidungen variieren in einem breiten Bereich, von kompakt bis porös und säulenförmig. Das Verhältnis O/Ti wird mit zunehmendem Druck grösser, wenn die übrigen Reaktionsparameter unverändert bleiben. Die Publikation beschäftigt sich schwergewichtig mit wissenschaftlichen Untersuchungen.

Der Erfindung liegt die Aufgabe zugrunde, einen Verbundwerkstoff und ein Verfahren zu dessen Herstellung mit einer funktionalen Titanoxidschicht der eingangs genannten Art zu schaffen, welche verbesserte, insbesondere synergetische Funktionalitäten für einen breiten Bereich von Substraten bringt. Eine Das in der WO 01/71055 A1 beschriebene Verfahren hat zum Ziel, photokatalytisch aktive Titandioxidschichten auf Glas herzustellen, ohne dass während dem Beschichtungsvorgang das Substrat aufgeheizt werden muss. Mit einem Sputterprozess werden amorphe (photokatalytisch nicht aktive) TitandioxidSchichten auf das Substrat bei weniger als 200°C abgeschieden. In der nachfolgenden thermischen Behandlung wird der Oberflächenwiderstand von 10⁹ bis 10¹³ Ω/ durch Verwendung einer inerten, reduzierenden oder in einer oxidierenden Atmosphäre eingestellt. Diese thermische Behandlung erfolgt bei 200°C bis 350°C. Erst durch diese thermische Nachbehandlung wird die photokatalytische Aktivität der Schicht erzeugt, welche im angegebenen Bereich des Oberflächenwiderstandes erhöht ist und mit einem Kontaktwinkel von < 65° charakterisiert ist. Eine stöchiometrische Titandioxidschicht (TiO_{2.0}) weist einen Oberflächenwiderstand von 10¹⁵ Ω/ und mehr auf. Im Beispiel 1 Seite 22 wird eine 500 nm dicke Titandioxid-Schicht abgeschieden und beschrieben wie durch die erhöhte Mobilität bei der thermischen Behandlung der Kristallisationsprozess beschleunigt wird und die Sauerstoff-Fehlstellen in der Dünnschicht kontrolliert werden. Als Substrat dient ein temperaturfestes Material, wie Glas. Wechselwirkung von Sauerstoff und anderen reaktiven Gasen mit dem Substrat sollen verhindert und dieses thermisch isoliert werden.

Bezüglich des Verbundwerkstoffs wird die Aufgabe erfindungsgemäss dadurch gelöst, dass auf dem Substrat eine Titanoxidschicht aus einer Grundschicht aus TiOₓ mit einem Sauerstoffgehalt von 0.7 ≤ x < 2 oder aus TiOₓ (OH)y mit einem Sauerstoffgehalt von 0.5 ≤ x < 2 und einem Hydroxidgehalt von 0 ≤ y < 0.5 und auf dieser Grundschicht eine Oberschicht aus amorphem und/oder kristallinem TiO₂ aufgebracht ist. Spezielle und weiterbildende Ausführungsformen des Verbundwerkstoffs sind Gegenstand von abhängigen Patentansprüchen.

Das Substrat mit einer Grundschicht und einer Oberschicht, allenfalls auch mit weiteren Schichten, wird hier und im übrigen einfachheitshalber als Verbundwerkstoff bezeichnet. Weiter umfasst, um Wiederholungen zu vermeiden, die Bezeichnung TiOₓ stets auch die Variante TiOₓ (OH)_{y}. Die BezeichnungenTiOₓ, TiOₓ (OH)_{y} und TiO₂ umfassen reine Titanoxidschichten, aber auch Titanoxidschichten mit anderen Metalloxiden, wobei die Grundschicht insgesamt weniger als 50 Gew.-%, die Oberschicht insgesamt weniger als 7 Gew.-% von anderen, im Folgenden detailliert aufgeführten Metalloxiden enthält.

Bei der erfindungsgemässen Titanoxidschicht handelt es sich um eine multifunktionale Schicht, welche ein Substrat z.B. vor Entflammung, Verunreinigung, Degradation (Migration von Additiven, Photooxidation) schützt. Dadurch kann ein beliebiges Material mit einer Flammschutzwirkung, einer Hygieneschutzwirkung (Selbstreinigung, keimabtötende Wirkung), einem Anti-Statik-Schutz und/oder einem Anti-Fogging-Effekt ausrüstet werden. Ein solcher Verbundwerkstoff eignet sich beispielsweise für den Einsatz im medizinalen Bereich, für Wohnaccessoires, Haushaltartikel, Textilien, Tapeten, Kabel und Photovoltaik sowie in Reinigungsanlagen für Wasser, wässrige Lösungen und Luft.

Als zu schützende Materialien besonders geeignet sind leicht entflammbare und/oder wärmeempfindliche Materialien wie Polymere, tiefschmelzende Metalle, Komposit-Werkstoffe und Naturstoffe in Form von starren bis flexiblen Folien, Geweben, Membranen, Fasern, Rohren, Platten, Behältern und Pulvern.

Die Titanoxidschicht hat vorzugsweise eine gesamte Schichtdicke von 3 bis 1000 nm, wobei mindestens 10% der gesamten Schichtdicke aus der Oberschicht besteht. Die Oberschicht besteht aus Titandioxid, TiO₂, in der Praxis ist der Übergang jedoch fliessend, ein Wert von TiO_{1,99} beispielsweise kann auch der Oberschicht zugerechnet werden. Weiter sind in der Praxis hauchdünne Schichten von nur 3 nm eher selten, zweckmässig liegt die gesamte Schichtdicke im Bereich von 10 bis 300 nm, insbesondere 20 bis 150 nm, wobei 10 bis 50% der gesamten Schichtdicke aus der Oberschicht bestehen.

Beim Einsatz von Kunststoff- und Naturstoffsubstraten (insbesondere Wolle und Baumwolle) kann eine Titandioxidschicht problematisch werden, sie kann auch als Katalysator eine Zersetzung der Oberfläche des Substrates auslösen. Bei Kunststoffen und Naturstoffen kann es deshalb angebracht sein, vor dem Auftragen der Grundschicht aus TiOₓ eine Schutzschicht aus wenigstens einem Metalloxid der Gruppe, welche bevorzugt aus MgO, ZnO, ZrO₂, In₂O₃, Sb₂O₃, Al₂O₃ und SiO₂ besteht und/oder eine polare Adhäsionsschicht als Haftvermittlungsschicht, aufzutragen. Die Wahl des optimalen Metalloxids oder der optimalen Mischung von Metalloxiden kann der Fachmann in Versuchen leicht ermitteln. Bei einer Grundschicht aus TiOₓ mit einem Sauerstoffgehalt x < 1.9 und/oder einem signifikanten Hydroxidgehalt von 0.2 < y < 0.7 besteht üblicherweise keine Gefahr für das Substrat.

Nach einer weiteren Variante der Titanoxidschicht kann zwischen der Grundschicht und der Oberschicht eine elektrisch leitende Zwischenschicht abgeschieden werden, welche vorzugsweise aus TiOₓ mit einem Sauerstoffgehalt von 0.5 ≤ x < 1.5 besteht. Die elektrische Leitfähigkeit nimmt ab einem Sauer stoffgehalt von x ≥ 1.5 ab. Die Schicht kann nicht mehr als elektrisch leitend bezeichnet werden, eine Oberschicht aus TiO₂ mit einem Sauerstoffgehalt von x = 2 ist ein Isolator. Offensichtlich wird eine elektrisch leitende Zwischenschicht insbesondere abgeschieden, wenn der Sauerstoffgehalt der Grundschicht oberhalb x = 1.5 liegt und falls ein Antistatikeffekt erzielt werden soll.

Wie später detaillierter erklärt wird, bestehen mindestens die obersten neun Atomlagen der Oberschicht hauptsächlich aus der kristallinen TiO₂-Modifikation Anatase, was einer Schichtdicke von etwa 3 nm entspricht.

Beim Einsatz der multifunktionalen Titanoxidschicht als Flammschutzschicht eines Kunststoffsubstrats können diesem submikrone Füllerpartikel aus einem Metalloxid, beispielsweise TiO₂ und/oder Sb₂ O₃, oder aus einem bei Hitze wasserabspaltenden Metallhydroxid beigemischt, beispielsweise Al (OH)₃ und/oder Sb (OH)₃. In diesem Fall hat die TiOₓ-Grundschicht zweckmässig einen Sauerstoffgehalt von 1.5 ≤ x≤ 1.9.

In Bezug auf das Verfahren zum Abscheiden einer chemisch, physikalisch, mechanisch, katalytisch und/oder optisch funktionalen Titanoxidschicht auf einem Substrat wird die Aufgabe nach einer ersten Variante erfindungsgemäss dadurch gelöst, dass vorerst eine reaktive Grundschicht aus TiOₓ mit einem Sauerstoffgehalt von 0.7 ≤ x < 2, dann durch Erhöhen des Sauerstoffgehalts, des Prozessdrucks, der Leistung und/oder der Substrattemperatur eine Oberschicht aus amorphem oder kristallinem TiO₂ abgeschieden wird.

Das Auftragen erfolgt mit an sich bekannten, bereits vorstehend erwähnten Methoden, aus verfahrenstechnischen Gründen sind Beschichtungsprozesse bei niedrigen Temperaturen bevorzugt. Eine allfällige Zwischenschicht zwischen der Grund- und der Deckschicht und eine Schutzschicht zwischen dem Substrat und der Grundschicht werden ebenfalls nach einem der erwähnten bekannten Methoden abgeschieden.

Vorzugsweise wird insbesondere bei einem Kunststoffsubstrat oder nicht-polaren Material, die Grundschicht oder die Schutzschicht nach einer Plasmaaktivierung der Oberfläche des Substrats aufgetragen. Dadurch wird die Haftung der abzuscheidenden Schicht erhöht. Die Vorbehandlung kann auch mittels einer hauchdünnen polaren Plasmaschicht von wenigen Nanometern Dicke erfolgen. Diese polare Plasmaschicht erhöht einerseits die Haftung der Grundschicht und verhindert andrerseits eine Degradation des Substrats. Für die Erzeugung einer langzeitstabilen polaren Schicht wird auf die WO 99/39842 verwiesen, nach welcher für eine polare Beschichtung ein wasserfreies Prozessgas eingesetzt wird, das mindestens je eine auch substituierte Kohlenwasserstoffverbindung bis zu 8 C/Atomen und ein anorganisches Gas enthält.

Die keramische Beschichtung kann direkt anschliessend an die Oberflächenbehandlung des Substrats oder später erfolgen.

Nach einer Weiterausbildung des Verfahrens kann eine mit wenigstens einem Metalloxid gemischte Grundschicht aus TiOx abgeschieden werden. Als Metalloxide sind beispielsweise MgO, ZnO, ZrO₂, In₂O₃, Sb₂O₃, Al₂O₃ und/oder SiO₂ geeignet, wobei der Anteil des TiOₓ nach dem Zumischen über 50 Gew.-% bleibt. Weiter können der Oberschicht aus TiO₂ auch Fe₂O₃, WO₃, MnO₂, NiO, BaO und/oder CaO zudotiert werden, wobei der Antil des Ti02 nach dem Dotieren über 93 Gew.-% bleibt. Werden der Grundschicht aus TiOx die Metalloxiden beider Gruppen zugegeben, muss der gesamte Anteil aller Metalloxide unter 50 Gew.-% bleiben, der Anteil der zudotierten Metalloxide der zweiten Gruppe muss unter 7 Gew.-% bleiben.

Die erfindungsgemässe Abscheidung einer Grundschicht aus TiOₓ (0.7 ≤ x < 2) und einer Oberschicht aus TiO₂ bringt zahlreiche, nachstehend nicht abschliessend aufgelistete Vorteile.
■ Das Verfahren kann bei < 200°C Substrattemperatur durchgeführt werden, was insbesondere für Polymersubstrate wichtig ist. Auch bei metallischen, keramischen und Komposit-Werkstoffen und Kombinationen daraus kann ein Niedertemperaturprozess angezeigt sein.
■ Die Abscheidung einer elektrisch leitfähigen TiOₓ-Schicht auf elektrisch nichtgleitenden Substraten reduziert die elektrostatische Aufladung und unterstützt dadurch synergetisch den Hygieneschutz.
■ Die Beschichtung eines organisch-chemischen Substrates (Polymer, Naturstoff) mit einer Grundschicht aus TiOₓ (x < 1.9) und/oder TiOₓ (OH)_{y} mit einem signifikanten Hydroxidanteil ist üblicherweise unproblematisch (keine Degradation).
■ Eine dünne Beschichtung hat den Vorteil; dass die mechanischen und verarbeitungstechnischen Eigenschaften des Substrats erhalten bleiben. Dies ist insbesondere wichtig bei einer Faser- und Folienbehandlung, welche anschließend noch mehrere Verarbeitungsprozesse zu überstehen haben.
■ Mit einem plasmaaktivierten Verfahren können vorgegebene Schichteigenschaften, wie Porosität, Kristallinität, Dichte, elektrische Leitfähigkeit, Brechungsindex und Polarität, gezielt hergestellt werden. Insbesondere kann durch die Kombination von dichten mit porösen nanostrukturierten Multischichten, welche auch unterschiedliche elektrische Leitfähigkeit und Brechungsindexes aufweisen können, eine synergetische Funktionalität der Titanoxidschicht erzielt werden. Beispielsweise kann die Topographie des Substrates mit einer geeigneten Schichttopographie derart verändert oder ergänzt werden, dass diese die Reinigungs-Hygienefunktion synergetisch verstärken kann.
■ Die synergetische Multifunktionalität der Titanoxidschichten kann der jeweiligen Anwendung angepasst werden kann. Die zur Herstellung der Schichtsysteme bevorzugten plasmaaktivierten Niedertemperatur-Verfahren, z.B. durch Magnetron Sputtern, Funken-Entladung und Plasma-MOCVD, eignen sich insbesondere dank der einfachen Prozessführung zur Variation der Stöchiometrie und der Schichtstruktur sowie der prozesstechnisch einfach durchführbaren Dotierung der Titanoxidschicht mit wenigstens einem Metalloxid, beispielsweise Fe₂O₃, zur Stabilisierung der Modifikation Anatase. Niedertemperatur-Verfahren sind deshalb auch für wärmeunempfindliche Materialien, wie Glas, interessant.

Dank einer erfindungsgemässen Titanoxidschicht mit einer Grundschicht aus TiOₓ und Oberschicht aus TiO₂, welche eine Dicke von > 3 nm, insbesondere >10 nm hat, ist auf praktisch allen Substraten ein Hygieneschutz, eine Biokompatibilität, ein Anti-Fogging Effekt und somit ein aktiver Flammschutz erzielbar. Dank der darunterliegenden TiOₓ-Grundschicht ist auch eine Biokompatibilität, ein Degradationsschutz des Substrates, ein passiver Flammschutz, ein Anti-statik-Effekt, ein Migrations- und ein Diffusionssperrschutz gewährleistet.

Eine photokatalytisch aktive Hygieneschutzschicht aus TiO₂ besitzt die Fähigkeit, in feuchter Atmosphäre und unter Tageslicht oder UV-Einstrahlung organische Verbindungen (Kohlenstoff und/oder Stickstoff enthaltende Verbindungen, wie Öl, Bakterien) an der Oberfläche zu zerstören. Dank der Reduktion des Kontaktwinkels zwischen Wasser und der TiO₂-Oberfläche der Oberschicht resultiert zusätzlich ein Anti-Fogging-Effekt und ein begünstigter Abtransport von Staubpartikeln. Dieser auch Selbstreinigungseffekt genannte Hygieneschutz verstärkt synergetisch den passiven Flammschutz, eines brennbaren Substrats. In diesem Fall handelt es sich um einen aktiven und reaktiven Flammschutz.

Beim passiven Flammschutz wird der direkte Kontakt der Atmosphäre mit einem leicht entflammbaren Substrat durch die erfindungsgemässe Beschichtung mit dem thermisch stabilem Titanoxid herabgesetzt werden, welches bei einem Brand eine Kruste aus erhitztem Titanoxid bildet. Die Flammausbreitungsgeschwindigkeit wird durch die Kruste reduziert und die Entwicklung von aus dem Substrat entweichenden Gasen wird herabgesetzt (Diffusionsbarriere), was schliesslich zur Auslöschung der Flamme durch passiven Schutz führen kann.

Die Erfindung wird anhand von in der Zeichnung dargestellten Ausführungsformen, welche auch Gegenstand von abhängigen Ansprüchen sind, näher erläutert. Die meist teilweisen Querschnitte zeigen schematisch:
- Fig. 1 einen folienförmigen Verbundwerkstoff mit einer einseitig abgeschiedenen Titanoxidschicht,
- Fig. 2 eine Variante gemäss Fig. 1 mit einer zweiteiligen Titanoxidschicht
- Fig. 3 eine Variante von Fig. 2 mit beidseits abgeschiedener Titanoxidschicht,
- Fig. 4 eine Faser mit einer dreiteiligen Titanoxidschicht, und
- Fig. 5 eine Variante gemäss Fig. 2 mit einer zusätzlichen Schutzschicht.

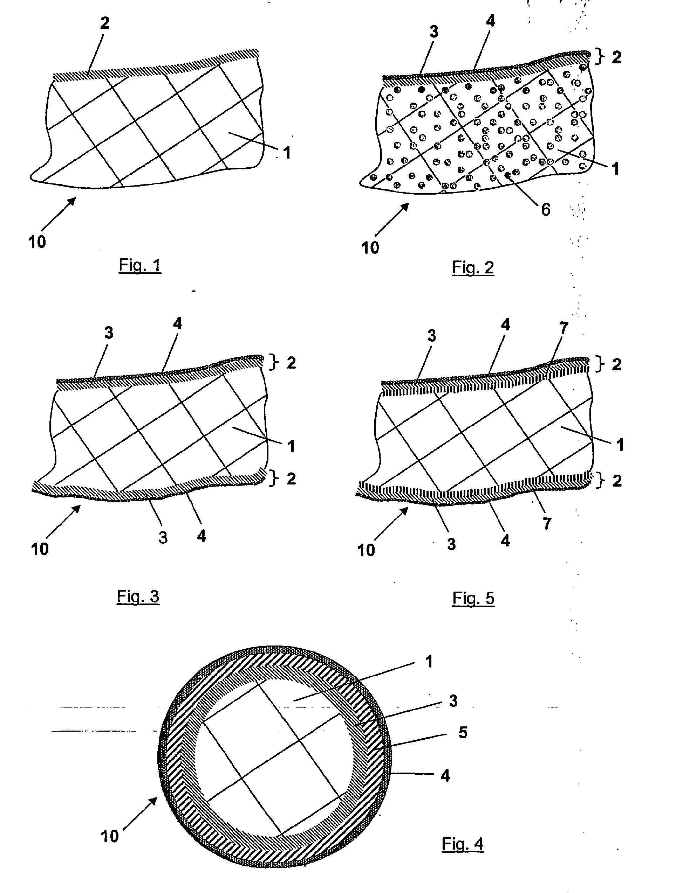

Fig. 1 zeigt einen Verbundwerkstoff 10 mit einem Substrat 1 und einer einseitig aufgebrachten Titanoxidschicht 2 ohne nähere Spezifizierung. Fig. 1 entspricht dem üblichen Stand der Technik, es ist eine Titanschicht 2 auf ein Substrat 1 aufgebracht, wo sie eine Schutz- oder andere Funktion erfüllt. Es ist eine dünne TiOₓ-Schicht aufgetragen worden, welche zu TiO₂ postoxidiert ist. Wegen der extrem dünnen Schicht ist die TiOₓ-Schicht über die ganze Dicke zu TiO₂ oxidiert worden. Das lediglich teilweise dargestellte Substrat 1 kann z.B. eine Folie, ein Gewebe, eine Membrane, eine Platte, eine Faser, ein Rohr, ein Kabel oder ein Behälterteil sein und aus einem üblichen Material bestehen.

In Fig. 2 ist die Titanoxidschicht 2 in eine Grundschicht 3 aus TiOₓ, wobei der Sauerstoffgehalt 0.7 ≤ x < 2 ist, und eine Oberschicht 4 aus TiO₂ unterteilt. Im Substrat 1 sind submikrone Partikel 6 aus einem Metalloxid/Metallhydroxid feindispers verteilt. Die Oberschicht 4 aus TiO₂ liegt mehrheitlich in der tetragonalen Kristallstruktur Anatase vor.

Der Übergang von der Grundschicht 3 zur Oberschicht 4 ist scharf gezeichnet. Falls die Grundschicht 3 mittels Postoxidation teilweise in eine Oberschicht, 4 umgewandelt wird, ist der Übergang fliessend.

Fig. 3 zeigt einen Verbundwerkstoff 10 mit beidseits aufgebrachter Titanoxidschicht 2. Die Struktur dieser Titanoxidschicht 2 entspricht derjenigen von Fig. 2.

In Fig. 4 ist das Substrat 1 eine Textilfaser, direkt auf der Grundschicht 3 ist eine elektrisch leitende Zwischenschicht 5 abgeschieden, welche die direkt auf der Faser abgeschiedene Grundschicht 3 zylindermantelförmig umhüllt. Diese elektrisch leitende Zwischenschicht 5 besteht aus TiOₓ und hat einen Sauerstoffgehalt von 0.7 < x < 1.5. Über der Zwischenschicht liegt die ebenfalls zylindermantelförmig ausgebildete Oberschicht 4.

Gewisse Kunststoffsubstrate werden von Titanoxidschichten zumindest oberflächlich zersetzt. In der Ausführungsform gemäss Fig. 5 ist deshalb eine Schutzschicht 7 direkt auf das Substrat 1 abgeschieden, wobei diese Schutzschicht 7 eine ebenfalls im Nanometerbereich liegende Dicke hat. Diese ebenfalls beidseits angebrachte Schutzschicht 7 besteht aus wenigstens einem Metalloxid, vorzugsweise der Gruppe ZnO, MgO, ZrO₂, In₂O₃, Sb₂O₃, Al₂O₃ und SiO₂, oder aus einer polaren Adhäsionsschicht, beispielsweise eine polare Plasmaschicht, welche zusätzlich eine gute Haftung zum Substrat 1 bewirkt.

### Tabelle 1

Die Beschichtungstechniken und Prozessparameter werden den Anforderungen an das zu beschichtende Substrat bzw. herzustellendes Produkt angepasst. In der Tabelle 1 ist die Herstellung von ausgewählten funktionalen TitanoxidSchichten und ihre Schutz- und/oder Funktionswirkung aufgeführt. In der Grundschicht B wurde ein relativ hoher Gehalt an Wasserstoff mit ERDA (Elastic Recolil Detection Analysis) analysiert, der in Form von Hydroxidionen in der Schicht gebunden ist und von den Prozessparametern und der Substrattemperatur abhängt.

Beidseitig beschichtete Verbundwerkstoffe werden jeweils mit derselben Schicht versehen. Während des Beschichtungsprozesses beträgt die Substrattemperatur < 200 °C. Der Anti-Fogging-Effekt wird bei einer Oberflächenspannung von > 50 mN/m und einer entsprechend glatten Oberfläche beobachtet. Die Oberflächenspannung hängt ebenfalls von den Prozessparametern bei der Herstellung der Schicht ab.

Die Wärmekapazität der beschichteten gewebeförmigen Substrate nimmt mit steigender Schichtdicke nahezu linear zu. Entsprechend der beschichteten Oberfläche ist der Effekt bei der PET-Folie höher als bei dem PET-Gewebe ersichtlich. Das dickere Gewebe-Gemisch bestehend aus 36% Polyester und 64% Viskose C weist einen deutlich weniger markanten Effekt auf, als das feine PET-Gewebe. Aus diesen Daten ist ersichtlich, dass die Schichtdicke dem jeweiligen Substrat (Material, Textur, Dicke) angepasst werden sollte, um den gewünschten Effekt zu erzielen.

Die durchschnittliche Flammausbreitungsgeschwihdigkeit sollte für Textilien allgemeiner Art weniger als 90 mm/s, für textile Vorhänge weniger als 60 mm/s betragen. Bereits mit einer 12 nm dünnen keramischen Beschichtung wird beim feinen PET-Gewebe der Grenzwert von 60 mm/s der Flammausbreitungsgeschwindigkeit unterschritten und erreicht bei einer Schichtdicke von 180 nm einen Wert von 31 mm/s. Beim Viskose/Polyester-Gemisch ist eine signifikante Reduktion von 142 auf 115 mm/s mit einer 95 nm dicken TiOₓ/TiO₂-Schicht erreicht worden.

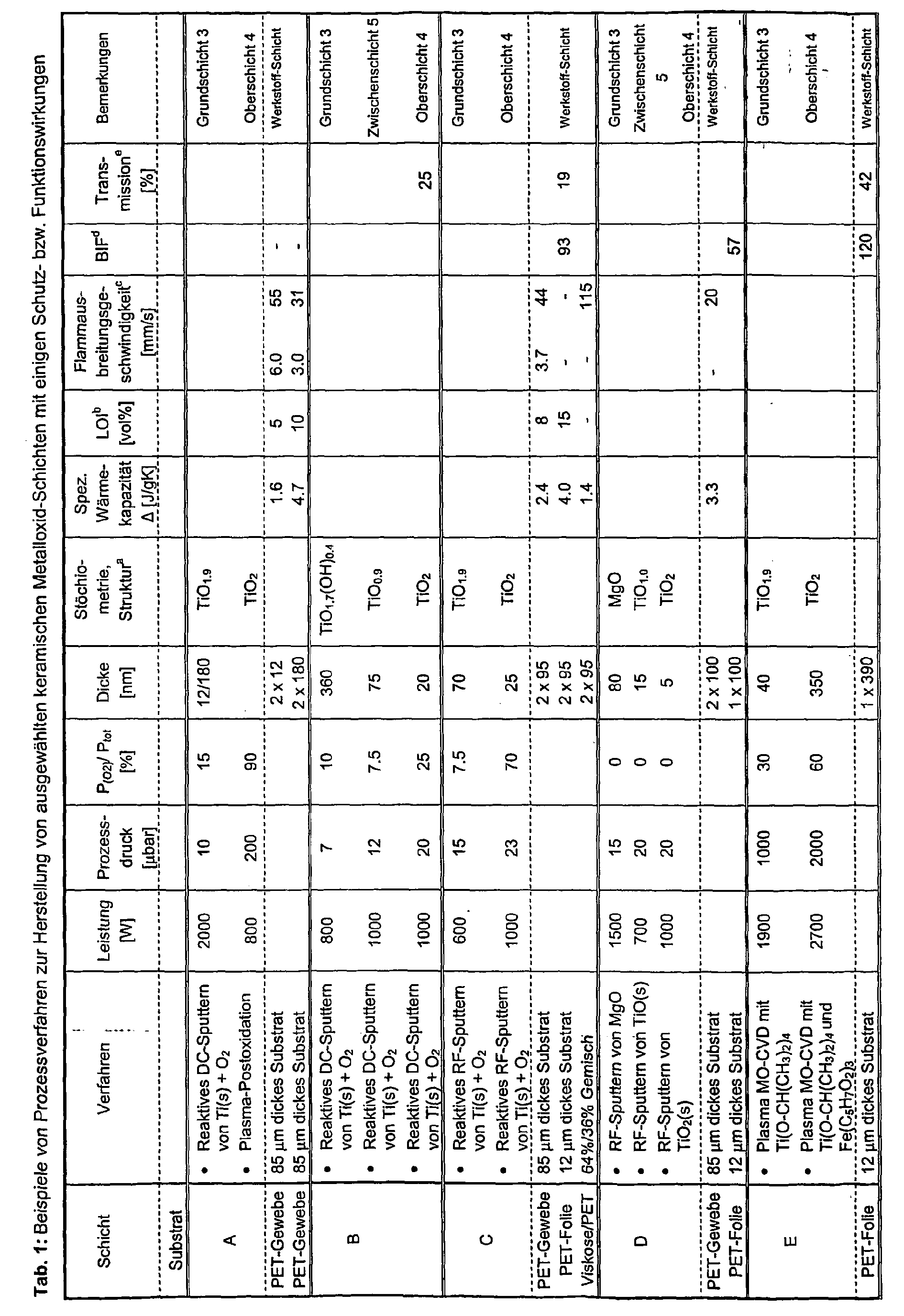

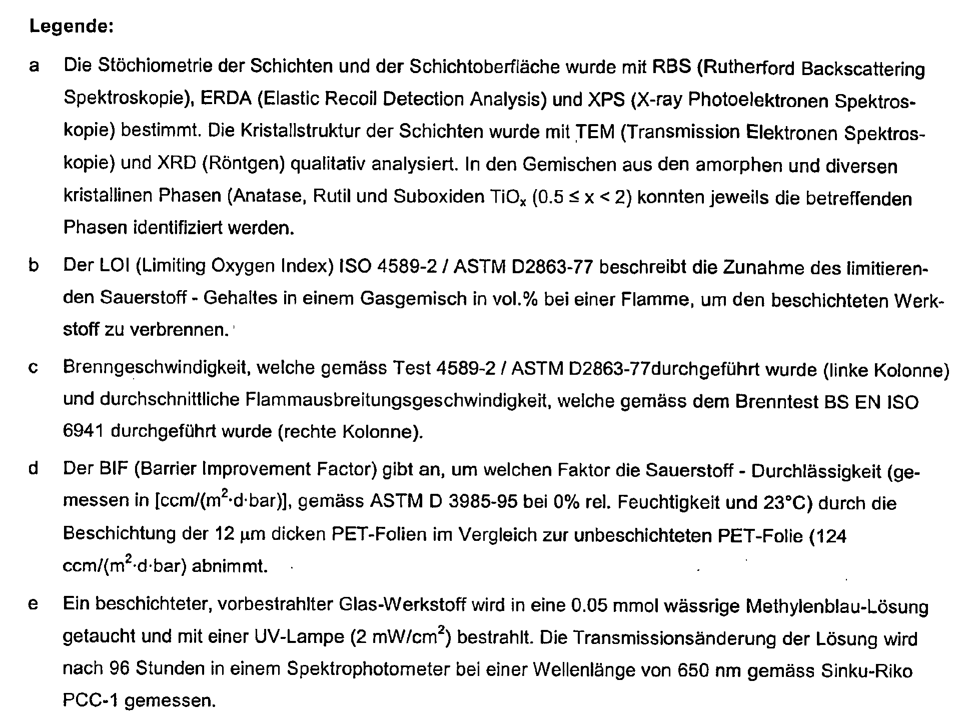

Die elektrische Leitfähigkeit bzw. der elektrische Widerstand der jeweiligen Zwischenschicht 5 ist in Beispiel 3 angegeben. Der elektrische Widerstand einer 100 nm dicken TiO₂-Schicht beträgt mehr als 2.10⁵ Ω cm.

### Beispiele

Im Folgenden werden einige Beispiele zur Herstellung von multifunktionalen Titanoxidschichten beschrieben. In jedem Fall werden die Schichteigenschaften und die Schichtstruktur den jeweiligen Produktanforderungen angepasst.

### Beispiel 1: Reaktives Magnetron Sputtern mit anschliessender Postoxidation

Abscheidung einer Titanoxid-Schicht 2 auf ein beliebiges Substrat 1 mit einem reaktiven Sputterprozess (DC = (gepulster) Gleichstrom; RF = Radiofrequenz) von Titan mit einem Gemisch von Prozessgasen aus Argon und Sauerstoff. Anschließend wird durch die Änderung der Plasmabedingungen (Variante 1 a) und/oder mit einer Postoxidation (Variante 1b) des Verbundwerkstoffs eine Anatase enthaltende TiO₂-Oberschicht 4 gebildet.

### Beschichtungsprozess:

- Target:: Titan-Metall (99.98 %)
- Leistung:: 1-7 W/cm² DC / RF
- Prozessdruck:: 10 µbar
- Partialdruck p(O₂)/p(tot):: 10 % DC / RF

### Variante 1a: TiO₂-Schicht am Schluss des Prozesses

In der letzten Phase des reaktiven Sputterprozesses wird der Prozessdruck auf 20 µbar erhöht und im Falle des DC-Sputterprozesses der Sauerstoff-Partialdruck auf 30 % erhöht, im Falle des RF-Sputterprozesses wird der SauerstoffPartialdruck auf 60 % erhöht. Die Erhöhung des Prozessdruckes und des Sauerstoff-Partialdruckes wirkt sich auf die Schichteigenschaften der Oberschicht günstig aus, welche sich durch eine tiefere Dichte, einer höheren Porosität und dadurch mit einer größeren Oberfläche auszeichnet.

### Variante 1b: Postoxidation von TiOₓ zu TiO₂

In diesem Fall wird die Titanoxid-Schicht mit einem PE-CVD bei Niederdruck bis Atmosphärendruck in einer oxidierenden Atmosphäre oxidiert. Die Eindringtiefe der Postoxidation hängt von der Dichte der TiOₓ-Schicht und von den Prozessbedingungen ab.
- Leistung (gepulst/kontin.):: 50 - 3000 W Radiofrequenz (MHz), Höchstfrequenz (GHz) oder Niederfrequenz (kHz)
- Prozessdruck:: 0.1 mbar bis 1 bar
- Partialdruck p(O₂)/p(tot):: 50-100%

### Beispiel 2: Haftvermittelnde Vorbehandlung und Plasma-aktiviertes MOCVD-Verfahren

Es erfolgt eine Plasma-Aktivierung eines Substrates (1), um die Adhäsion der Beschichtung zu erhöhen.

### Vorbehandlung:

- Leistung (gepulst / kontin.):: 200 - 1500 W Höchstfrequenz (2.45 GHz)
- Prozessdruck:: 20 µbar bis 1 bar
- Partialdruck p(O₂/N₂O)/p(tot):: 20-80%

### Grundschicht 4 bestehend aus TiOₓ oder TiOₓ gemischt mit SiOₓ:

Anschliessend wird ein titan-haltiges Monomergas, beispielsweise Titan-Tetrakis-Isopropoxid (TTIP) (Ti(O-CH(CH₃)₂)₄) gemeinsam mit Sauerstoff und einem oder mehreren Edelgasen (Ar, He) in die Reaktionskammer eingeleitet und eine TiOₓ-Schicht 4 abgeschieden. Zusätzlich kann Hexamethyldisiloxan (HMDSO) in den Plasmaprozess eingeleitet werden, so dass ein Verhältnis der beiden Metalloxide von 2:1 in der Grundschicht entsteht.
- Leistung (gepulst / kontin.):: 600 - 3500 W Höchstfrequenz (2.45 GHz)
- Prozessdruck:: 10 µbar - 0.1 bar
- Prozessgase:: Ar / He als Trägergas durch Ti(O-CH(CH₃)₂)₄ bei 50 °C, Ar / He und O₂

### Oberschicht 4 bestehend aus TiO₂ oder TiO₂ dotiert mit Fe₂O₃:

Auf die Grundschicht 3 werden anschließend zu den titanhaltigen Prozessgasen ein eisenhaltiges Monomergas in kleiner Menge (bsp. Eisen-acetylacetonat-Komplex Fe(C₅H₇O₂)₃, mit Sauerstoff und einem oder mehreren Edelgasen (Ar, He, etc.) als Trägergas in die Reaktionskammer eingeleitet, um eine Anatase enthaltende TiO₂-Oberschicht 4 dotiert mit 0.1-9 at% Fe₂O₃ abzuscheiden. Gleichzeitig kann durch Variation der Prozessparameter die Schichtstruktur geändert werden.
Mit Hilfe von zahlreichen energiereichen plasma-aktivierten Entladungen vom Niederfrequenz- bis zum Höchstfrequenzbereich und Kombinationen daraus ist es möglich die beschriebenen Verbundwerkstoffe herzustellen. Als Beispiele werden genannt: (Remote) AP-PECVD (atmospheric pressure plasma enhanced chemical vapour deposition), APNEP (atmospheric pressure nonequilibrium plasma) Plasma-Jet, Plasmabreitstrahlbrenner, Mikrowellen-Entladung, Pulsing Surface Discharge, DBD (Dielectric Barrier Discharge), APGD (Atmopheric Pressure Glow Discharge).

### Beispiel 3: Elektrisch leitfähige TiOₓ-Zwischenschicht 5

Es wird eine elektrisch leitfähige Zwischenschicht 5 hergestellt, welche leitfähiger als die Grundschicht 3 und/oder die zusätzliche Grundschicht 7 ist. Die TiOₓ-Schicht (0.7 ≤x < 1.5) wird auf ein mit einer Grundschicht 3 versehenen beliebigen Substrat 1 abgeschieden, indem bei einem reaktiven Sputterprozess weniger Sauerstoff-Gas als bei der Grundschicht 3 dem Prozess zugeführt wird und der Prozessdruck angepasst wird. Es besteht auch die Möglichkeit, eine TiOₓ-Schicht nicht-reaktiv mit einem Sputterprozess abzuscheiden, indem ein entsprechendes Target (TiO, Ti₂O₃, Ti₃O₂, etc.) verwendet wird.

### Reaktiver DC-Sputterprozess um eine TiO_{1.0}-Schicht mit einem elektrischen Widerstand von 1.2·10⁻² Ω cm bzw. 50 Ω cm zu erhalten:

- Target:: Titan-Metall (99.98 %)
- Leistung:: 3 W/cm² DC
- Prozessdruck:: 20 µbar bzw. 7 µbar
- Partialdruck p(O₂)/p(tot):: 5 % bzw. 7.5 %

## Patentansprüche

1. Verbundwerkstoff (10) aus einem Substrat (1) mit einer wenigstens einseitig aufgebrachten chemisch, mechanisch, physikalisch, katalytisch und/oder optisch funktionalen Titanoxidschicht (2), wobei auf dem Substrat (1) eine Titanoxidschicht (2) aus einer Grundschicht (3) aus TiOₓ mit einem Sauerstoffgehalt von 0.7 ≤ x < 2 oder aus TiOₓ (OH)_{y} mit einem Sauerstoffgehalt von 0.5 ≤ x < 2 und einem Hydroxidgehalt von 0 ≤ y < 0.7 und auf dieser Grundschicht (3) eine Oberschicht (4) aus amorphem und/oder kristallinem TiO₂ aufgebracht ist, **dadurch gekennzeichnet, dass** die Titanoxidschicht (2) eine gesamte Schichtdicke von 10 bis 300 nm aufweist, wobei mindestens 10% der gesamten Schicht (2) aus der Oberschicht (4) bestehen.

2. Verbundwerkstoff (10) nach Anspruch 1, **dadurch gekennzeichnet, dass** die Titanoxidschicht (2) eine gesamte Schichtdicke von 20 bis 150 nm aufweist.

3. Verbundwerkstoff (10) nach einem der Ansprüche 1 bis 2, **dadurch gekennzeichnet, dass** zwischen dem Substrat (1) und der Grundschicht (3) der Titanoxidschicht (2) eine Schutzschicht (7) aus wenigstens einem Metalloxid der Gruppe, bestehend aus ZnO, MgO, ZrO₂, In₂O₃, Sb₂O₃, Al₂O₃ und SiO₂, und/oder einer polaren Adhäsionsschicht, abgeschieden ist, vorzugsweise mit höchstens gleicher Schichtdicke wie die Titanoxidschicht (2).

4. Verbundwerkstoff (10) nach einem der Ansprüche 1 bis 3, **dadurch gekennzeichnet, dass** der Grundschicht (3) aus TiOₓ wenigstens ein Metalloxid der Gruppe, bestehend aus MgO, ZnO, ZrO₂, In₂O₃, Sb₂O₃, Al₂O₃ und SiO₂, zugemischt und/oder wenigstens ein Metalloxide der Gruppe, bestehend aus Fe₂O_{3,} WO₃, MnO₂, NiO. BaO und CaO, zudotiert ist, wobei der gesamte Anteil aller Metalloxide unterhalb 50 Gew.-% und der gesamte Anteil der Metalloxide der zweiten Gruppe unterhalb 7 Gew.-% bleibt.

5. Verbundwerkstoff (10) nach einem der Ansprüche 1 bis 4, **dadurch gekennzeichnet, dass** zwischen der Grundschicht (3) und der Oberschicht (4) der Titanoxidschicht (2) eine elektrisch leitende Zwischenschicht (5) abgeschieden ist, welche vorzugsweise aus TiOₓ mit einem Sauerstoffgehalt von 0.7 ≤ x ≤ 1.5 besteht.

6. Verbundwerkstoff (10) nach einem der Ansprüche 1 bis 5, **dadurch gekennzeichnet, dass** mindestens die neun obersten Atomlagen der Oberschicht (4) der Titanoxidschicht (2) vorwiegend aus der TiO₂-Modifikation Anatase bestehen.

7. Verbundwerkstoff (10) mit einem Kunststoffsubstrat (1) nach einem der Ansprüche 1 bis 6, **dadurch gekennzeichnet, dass** dem Kunststoffsubstrat (1) vorzugsweise submikrone Füllerpartikel (6) aus einem Metalloxid oder einem bei Hitze wasserabspaltenden Metallhydroxid feindispers zugemischt sind.

8. Verbundwerkstoff (10) mit einem entflammbaren Substrat nach einem der Ansprüche 1 bis 7, **dadurch gekennzeichnet, dass** die TiOₓ-Grundschicht (3) der Titanoxidschicht (2) einen Sauerstoffgehalt von 1.5 ≤ x ≤ 1.9 oder die TiOₓ (OH)_{y} einen signifikanten Hydroxidgehalt von vorzugsweise 0.2 < y < 0.7 aufweist, hat.

9. Verfahren zum Abscheiden einer chemisch, physikalisch, mechanisch, katalytisch und/oder optisch funktionalen Titanoxidschicht (2) auf einem Substrat (1), **dadurch gekennzeichnet, dass** vorerst reaktiv oder nicht reaktiv eine Grundschicht (3) auf TiOₓ mit einem Sauerstoffgehalt von 0.7 ≤ x < 2, dann durch Erhöhen des Sauerstoffgehalts, des Prozessdrucks, der Leistung und/oder der Substrattemperatur, eine Oberschicht (4) aus amorphem und/oder kristallinem TiO₂ abgeschieden wird, derart dass die Titanoxidschicht (2) eine gesamte Schichtdicke von 10 bis 300 nm aufweist, wobei mindestens 10% der gesamten Schicht (2) aus der Oberschicht (4) bestehen, und dass die Substrattemperatur während der Abscheidung < 200°C beträgt.

10. Verwendung eines Verbundwerkstoffs (10) mit einem Substrat (1) aus einem Kunststoff nach einem der Ansprüche 1 bis 8 zur Erhöhung der thermischen Stabilität und Flammhemmung bei polymeren Materialien in Form von Folien, Membranen, Fasern, Pulvern, Textilien, Geweben, Rohren und Behältern.

11. Verwendung eines Verbundwerkstoffs (10) nach einem der Ansprüche 1 bis 8 als aktiver Hygieneschutz für die Aufbereitung von Trinkwasser, wässrigen Lösungen und Luft, für Textilien, Vorhänge, Tapeten, Folien, Membrane, Kabel, Verpackungen, Glaswaren, Fenster, Composit-Werkstoffe, Elemente der Medizinaltechnik, Photo-Voltaik und optische Systeme, Gassensoren und elektronische Schaltkreise.

## Claims

1. Composite material (10) of a substrate (1) with at least one chemically, mechanically, physically, catalytically and/or optically functional titanium oxide coating (2) applied on at least one side, wherein on the substrate (1) is applied a titanium oxide coating (2) of a base layer (3) of TiOₓ with an oxygen content of 0.7 ≤ X < 2 or TiOₓ (OH)_{y} with an oxygen content of 0.5 ≤ X < 2 and a hydroxide content of 0 ≤ y < 0.7, and on this base layer (3) is applied a top layer (4) of amorphous and/or crystalline TiO₂, **characterised in that** the titanium oxide coating (2) has a total layer thickness of 10 to 300 nm, wherein at least 10% of the entire coating (2) comprises the top layer (4).

2. Composite material (10) according to claim 1, **characterised in that** the titanium oxide coating (2) has a total layer thickness of 20 to 150 nm.

3. Composite material (10) according to one of claims 1 or 2, **characterised in that** between the substrate (1) and the base layer (3) of the titanium oxide coating (2) is deposited a protective layer (7) of at least one metal oxide of the group comprising ZnO, MgO, ZrO₂, In₂O₃, Sb₂O₃, Al₂O₃ and SiO₂ and/or a polar adhesion layer, preferably with maximum the same layer thickness as the titanium oxide coating (2).

4. Composite material (10) according to any of claims 1 to 3, **characterised in that** mixed into the base layer (3) of TiOₓ is at least one metal oxide of the group comprising MgO, ZnO, ZrO₂, In₂O₃, Sb₂O₃, Al₂O₃ and SiO₂ and/or doped into said layer is at least one metal oxide from the group comprising Fe₂O₃, WO₃, MnO₂, NiO, BaO and CaO, wherein the entire proportion of all metal oxides is less than 50 w.% and the entire proportion of metal oxides of the second group is less than 7 w.%.

5. Composite material (10) according to any of claims 1 to 4, **characterised in that** between the base layer (3) and the top layer (4) of the titanium oxide coating (2) is deposited an electrically conductive intermediate layer (4) which preferably comprises TiOₓ with an oxygen content of 0.7≤X≤ 1.5.

6. Composite material (10) according to any of claims 1 to 5, **characterised in that** at least the nine top atom layers of the top layer (4) of the titanium oxide coating (2) comprise predominantly the TiO₂ modification anatase.

7. Composite material (10) with a plastic substrate (1) according to any of claims 1 to 6, **characterised in that** mixed finely dispersed into the plastic substrate (1) are preferably submicron filler particles (6) of a metal oxide and/or a metal hydroxide which eliminates water under heat.

8. Composite material (10) with a non-flammable substrate according to any of claims 1 to 7, **characterised in that** the TiOₓ base layer (3) of the titanium oxide coating (2) has an oxygen content of 1.5 ≤ X ≤ 1.9 or the TiOₓ (OH)_{y} has a significant hydroxide content of preferably 0.2 < y < 0.7.

9. Method for depositing a chemically, physically, mechanically, catalytically and/or optically functional titanium oxide coating (2) on a substrate (1), **characterised in that** first reactively or non-reactively a base layer (3) is deposited of TiOₓ with an oxygen content of 0.7 ≤ X < 2, then by increasing the oxygen content, the process pressure, the power and/or the substrate temperature, a top layer (4) of amorphous and/or crystalline TiO₂ is deposited such that the titanium oxide coating (2) has a total layer thickness of 10 to 300 nm, wherein at least 10% of the entire coating (2) comprises the top layer (4), and the substrate temperature during deposition is < 200°C.

10. Use of a composite material (10) with the substrate (1) of a plastic according to any of claims 1 to 8 to increase the thermal stability and flame inhibition in polymer materials in the form of foils, membranes, fibres, powders, textiles, fabrics, tubes and containers.

11. Use of a composite material (10) according to any of claims 1 to 8 as an active hygiene protection for the preparation of drinking water, watery solutions and air, for textiles, curtains, wall coverings, foils, membranes, cables, packaging, glassware, windows, composite materials, elements in medical technology, photo voltaic and optical systems, gas sensors and electronic circuits.

## Revendications

1. Matériau composite (10), formé d' un substrat (1) pourvu, au moins sur une face, d' une couche (2) d'oxyde de titane à fonction chimique, mécanique, physique, catalytique et/ou optique, dans lequel une couche (2) d'oxyde de titane constituée d' une couche de base (3) de TiOₓ à teneur en oxygène de 0,7 ≤ x < 2 ou de TiOₓ(OH)_{y} à teneur en oxygène de 0,5 ≤ x < 2 et à teneur en hydroxyde de 0 ≤ y < 0,7 est déposée sur le substrat (1) et une couche supérieure (4) de TiO₂ amorphe et/ou cristallin est déposée sur cette couche de base (3), **caractérisé en ce que** l'épaisseur totale de couche de la couche (2) d'oxyde de titane est de 10 à 300 nm, la couche supérieure (4) constituant au moins 10% de la couche totale (2).

2. Matériau composite (10) selon la revendication 1, **caractérisé en ce que** l'épaisseur totale de couche de la couche (2) d'oxyde de titane est de 20 à 150 nm.

3. Matériau composite (10) selon la revendication 1 ou 2, **caractérisé en ce qu'**une couche de protection (7) constituée d'au moins un oxyde métallique du groupe formé par ZnO, MgO, ZrO₂, In₂O₃, Sb₂O₃, Al₂O₃ et SiO₂ et/ou d'une couche polaire d'adhérence, d' une épaisseur de couche de préférence au plus égale à celle de la couche (2) d'oxyde de titane, est déposée entre le substrat (1) et la couche de base (3).

4. Matériau composite (10) selon l'une quelconque des revendications 1 à 3, **caractérisé en ce qu'**au moins un oxyde métallique du groupe formé par MgO, ZnO, ZrO₂, In₂O₃, Sb₂O₃, Al₂O₃ et SiO₂ est ajouté par mélange à la couche de base (3) en TiOₓ et/ou qu'au moins un oxyde métallique du groupe formé par Fe₂O₃, WO₃, MnO₂, NiO, BaO et CaO y est ajouté par dopage, d' une manière telle que la teneur totale de tous les oxydes métalliques reste inférieure à 50% en poids et la teneur totale des oxydes métalliques du deuxième groupe reste inférieure à 7% en poids.

5. Matériau composite (10) selon l'une quelconque des revendications précédentes, **caractérisé en ce qu'**une couche intermédiaire électriquement conductrice (5), qui se compose de préférence de TiOₓ à teneur en oxygène de 0,7 ≤ x ≤ 1,5, est déposée entre la couche de base (3) et la couche supérieure (4) de la couche (2) d'oxyde de titane.

6. Matériau composite (10) selon l'une quelconque des revendications précédentes, **caractérisé en ce qu'**au moins les neuf couches atomiques les plus élevées de la couche supérieure (4) de la couche (2) d'oxyde de titane se composent principalement d'anatase produit par modification de TiO₂.

7. Matériau composite (10) à substrat (1) en matière plastique selon l'une quelconque des revendications précédentes, **caractérisé en ce que** des particules de charges (6) de préférence submicroniques, constituées d'un oxyde métallique ou d'un hydroxyde métallique se déshydratant sous l'effet de la chaleur, sont ajoutées par mélange, sous forme finement dispersée, dans le substrat (1) de matière plastique.

8. Matériau composite (10) à substrat inflammable selon l'une quelconque des revendications précédentes, **caractérisé par** une teneur en oxygène de 1,5 ≤ x ≤ 1,9 dans le TiOₓ, ou une teneur significative en hydroxyde de préférence de 0,2 < y < 0,7 dans le TiOₓ(HO)_{y}, dans la couche de base (3) de la couche (2) d'oxyde de titane.

9. Procédé de dépôt d' une couche (2) d'oxyde de titane à fonction chimique, physique, mécanique, catalytique et/ou optique sur un substrat (1), **caractérisé en ce qu'**une couche de base (3) en TiOₓ à teneur en oxygène de 0,7 ≤ x < 2 est d'abord déposée de manière réactive ou non réactive et une couche supérieure (4) de TiO₂ amorphe et/ou cristallin y est ensuite déposée en élevant la teneur en oxygène, la pression de traitement, la puissance et ou la température du substrat, d' une manière telle que l'épaisseur totale de couche de la couche (2) d'oxyde de titane est de 10 à 300 nm, la couche supérieure (4) constituant au moins 10% de la couche totale (2) et la température de substrat étant < 200°C pendant le dépôt.

10. Utilisation d'un matériau composite (10) à substrat (1) en matière plastique selon l'une quelconque des revendications 1 à 8 pour élever la stabilité thermique et l'ignifugation de matières polymères en forme de feuilles, membranes, fibres, poudres, textiles, tissus, tubes et réservoirs.

11. Utilisation d'un matériau composite (10) selon l'une quelconque des revendications 1 à 8 comme protection hygiénique pour la préparation d'eau potable, de solutions aqueuses et d'air pour des textiles, des rideaux, des tapis, des feuilles , des membranes, des câbles, des emballages, de la verrerie, des fenêtres, des matériaux composites , des éléments de technique médicale, des systèmes photovoltaïques et optiques, des capteurs de gaz et des circuits électroniques.
